# EUROPÄISCHE PATENTSCHRIFT

(11) **EP 1 164 388 B1**
(45) Veröffentlichungstag und Bekanntmachung des Hinweises auf die Patenterteilung: **17.10.2007**
(21) Anmeldenummer: 01107966.2
(22) Anmeldetag: 29.03.2001
(51) Int. Cl.: G02B 1/04

(54) **Verfahren zum Herstellen eines Gegenstands, der optische Schichten aufweist**
Method of fabrication of a device with optical layers
Méthode de fabrication d'un élément avec des couches optiques

(30) Priorität: 17.06.2000 DE 10029905
(43) Veröffentlichungstag der Anmeldung: 19.12.2001
(73) Patentinhaber: Schott AG, 55122 Mainz (DE)
(72) Erfinder: Moelle, Christoph, Dr., 37581 Bad Gandersheim (DE); Küpper, Thomas, 37581 Bad Gandersheim (DE); Bewig, Lars, Dr., 37581 Bad Gandersheim (DE); Maring, Wolfram, Dr., 37581 Bad Gandersheim (DE); Heinz, Jochen, Dr., 55578 Vendersheim (DE)
(74) Vertreter: Dr. Weitzel & Partner

(56) Entgegenhaltungen:
- DE-A- 10 010 766
- DE-C- 4 008 405
- DE-C- 19 540 414
- GB-A- 2 105 729
- US-A- 4 935 661
- US-A- 5 369 722
- US-A- 6 025 013

## Beschreibung

Die Erfindung betrifft einen Gegenstand, umfassend ein Substrat aus einem Kunststoff, sowie eine Mehrzahl optischer Schichten. Solche Gegenstände können optische Bauteile sein wie Linsen, Prismen, Reflektoren.

Ein Reflektor umfaßt einen im wesentlichen trichterähnlichen Grundkörper, der auf seiner Innenfläche reflektierend beschichtet ist. Reflektoren dieser Art sind Bestandteile von Leuchten aller möglicher Art, wie beispielsweise Scheinwerfer. Sie bestehen aus den Materialien Glas, Metall oder Kunststoff. Die im automobilen Bereich verwendeten Metall- und Kunststoffreflektoren sind mit einer metallischen reflektierenden Fläche versehen, die auch die Wärmestrahlung reflektiert.

Im Bereich solcher Reflektoren fallen erhebliche Wärmemengen an, die örtlich zu Temperaturen von bis zu 200° C führen. Sind die Reflektoren aus Glas, so treten bezüglich der genannten Temperaturen keine Probleme auf.

Kaltlichtbeschichtete Reflektoren aus Glassubstraten finden sich heute unter anderem im Allgemeinbeleuchtungsbereich oder im Theaterbeleuchtungsbereich. Die Kaltlichtbeschichtung reflektiert dabei nur die sichtbare Strahlung und transmittiert die Wärmestrahlung.

Aufgrund der heutigen Scheinwerfergeometrien in Kraftfahrzeugen mit metallisch beschichteten Reflektoren führt die so reflektierte Infrarotstrahlung zu lokal hohen thermischen Belastungen an Komponenten, welche im Strahlengang folgen, wie z.B. Linsen, Abdeckscheiben u.a.. Aufgrund dieser Belastung müssen diese Komponenten heute in der Regel als Glassubstrate eingesetzt werden und/oder durch spezielle Beschichtungen vor der Wärmestrahlung geschützt werden.

In der Automobilindustrie geht es in zunehmendem Maße um die Einsparung von Gewicht, da eine Gewichtsreduzierung zur Einsparung von Kraftstoff beiträgt. Aus diesem Grunde wird versucht, soweit wie möglich Kunststoff als Austauschstoff für andere Materialien, beispielsweise für Stahl, zu verwenden. Im Falle des Glasreflektors war dies bisher jedoch nicht möglich. Die reflektierende Fläche müßte nämlich mit einem Kaltlichtspiegel versehen werden. Dies scheiterte bisher daran, daß es nicht möglich war, einen solchen Kaltlichtspiegel dauerhaft an einem Kunststoff zu fixieren.

Es sind auch Verfahren zum Herstellen von Gegenständen bekannt, umfassend Kunststoffsubstrate mit hierauf befindlichen Schichten. Ein solches Verfahren ist in DE 195 23 444 A1 beschrieben. Dabei wird ein Kunststoff mittels eines plasmaunterstützten CVD-Verfahrens (PICVD-Verfahren) durch eine elektrische Hochfrequenzentladung bei vermindertem Gasdruck mit einer Schutzschicht versehen. Dabei geht es um das Erzielen einer möglichst hohen Zähigkeit dieser Schicht zur Vermeidung der Versprödung.

DE 197 03 538 A1 beschreibt ein Verfahren zum Modifizieren von Oberflächen von PMMA-Substraten. Hierbei wird die Substrat-Oberfläche mit einer schützenden Schicht versehen. Damit soll sich eine verbesserte Haftung für nachfolgend aufzubringende Funktionsschichten erreichen lassen. Das Aufbringen der genannten Schutzschicht stellt einen zusätzlichen Verfahrensschritt dar und bedeutet somit zusätzlichen Aufwand und Kosten.

Weitere Verfahren zum Aufbringen dünner Schichten auf KunststoffSubstrate sind beschrieben in DE 34 13 019 A1, EP 0 422 323 A1, DE 40 04 116 A1 und anderen. Dabei geht es unter anderem auch um die Haftung der Schicht, die auf das Substrat aufgebracht wird, und zwar mittels des CVD- oder PICVD-Verfahrens. DE 100 10 766 zeigt und beschreibt ein Verfahren und eine Vorrichtung zur Beschichtung von insbesondere gekrümmten Substraten, beispielsweise von Brillengläsern.

DE 40 08 405 A beschreibt die Herstellung optischer Schichten auf einem Kunststoffsubstrat.

Die bisher angewandten Verfahren haben nicht befriedigt. Dabei wurde Die bisher angewandten Vorfahren haben nicht befriedigt. Dabei wurde nicht die notwendige Haftfestigkeit erzielt. Vielmehr besteht bei derart hergestellten Gegenständen die Gefahr des Lösens der genannten Zwischenschicht, und damit des gesamten Schichtpaketes. Dies kann dazu führen, daß der Gegenstand vorzeitig unbrauchbar wird.

US-A-5369722 beschreibt ein Verfahren zur Herstellung von Wellenleitern, die eine Haftverneitlerschicht aufweisen.

Der Erfindung liegt die Aufgabe zugrunde, ein Verfahren anzugeben, mit welchem ein Substrat aus Kunststoff dauerhaft und zuverlässig mit optischen Schichten versehen werden kann. Insbesondere soll hiermit eine Dauerhaftfestigkeit der Schichten am Substrat sowie der Schichten untereinander erreicht werden.

Diese Aufgabe wird durch die Merkmale des unabhängigen Anspruchs 1 gelöst.

Die Erfinder haben erkannt, daß eine dauerhafte und zuverlässige Fixierung der Wechselschichten am Kunststoff sowie der Wechselschichten untereinander erzielbar ist, wenn die Wechselschichten mit einem ganz bestimmten Verfahren auf das Kunststoffsubstrat aufgebracht werden, nämlich mittels des sogenannten PICVD-Verfahrens (chemische Plasma-Impuls-Bedampfung).

Bei den bisher angewandten PICVD-Verfahren zum Aufbringen von Schichten auf einem Substrat wird das Interface des Substrates durch die damit verbundene Energiebelastung gestört oder In seiner Struktur zerstört. Dies hat eine Verringerung der Haftfähigkeit zwischen Substrat und angrenzender Schicht zur Folge. Demgemäß haben die Erfinder erkannt, daß die Energiebelastung, die mit der Plasmaentladung verbunden ist, minimiert werden muß, um die Haftung zu steigern. Dabei geht es sowohl um das Maß der aufgebrachten Energie als auch um die Art und Weise ihres Aufbringens. Der zulässige Grenzwert der Belastung zum Erzielen einer in der Praxis ausreichenden Haftung läßt sich durch den Versuch ermitteln.

Durch die Erfindung lassen sich die an sich bekannten Vorteile von Kunststoff nutzen, insbesondere das geringe Gewicht und die leichte Verformbarkeit, was im Automobilbau eine besondere Rolle spielt, als auch das Vermeiden der Gefahren, die mit einem Splittern von Glas verbunden sind. Außerdem kann gegebenenfalls auf die Verwendung von Grundierschichten wie Grundierlacken verzichtet werden.

Als Kunststoffe kommen Hochleistungskunststoffe in Betracht, die möglichst bis zu einer Temperatur von 100 Grad Celsius oder mehr stabil sind. Hier wirkt sich wiederum das PICVD-Verfahren günstig aus, da die Substrat-Temperatur relativ gering gehalten wird. Die erzeugten Schichten selbst sind hart und dauerhaft.

Als besonders günstig haben sich als Kunststoffe die folgenden Stoffe erwiesen:
* Cycloolefin-Polymere (COP)
* Cycloolefin-Copolymere (COC)
* bzw. Derivate dieser Stoffe.

Mehrere Eigenschaften der COP- und COC-Kunststoffe machen Bauelemente aus COP-COC-Kunststoffen mit optischen Interferenzschichtsystemen für den Einsatz als optische Komponenten mit/ohne Vergütung/Beschichtung besonders geeignet:
(i) hohe Transparenz mit sichtbaren und nahmen infraroten Spektralbereich, niedrige Doppelbrechung
   → geringe Lichtverluste und geringe Aufheizung durch Wärmeabsorption
(ii) hohe Wärme-Formstabilität
(iii) Bauteile aus COP/COC können mit vergleichbarer Präzision wie Glas gefertigt werden
(iv) Barrierewirkung insbesondere gegen Wasserdampf
   → vorteilhaft für gute Haftung von Schichtsystemen

Aufgrund der genannten Eigenschaften können COP- und COC-Kunststoffe in vielen Anwendungsfällen Glassubstrate ersetzen und eröffnen damit neue Möglichkeiten im Design und der Auslegung optischer Systeme. In Kombination mit speziell angepaßten Interferenzschichtsystemen sind hochwertige optische Komponenten herstellbar.

Mit dem PICVD-Verfahren hat man eine Beschichtungstechnologie an der Hand, die sich neben der Beschichtung von Glas u. a. auch hervorragend für die Kunststoff-Beschichtung eignet. Ein Anwendungsbeispiel hierfür ist ein Kunststoffreflektor mit Kaltlichtspiegelung, wie er vor allem für die Automobilindustrie von Interesse ist. Kaltlichtbeschichtete Reflektoren aus Glassubstraten finden sich heute unter anderem im Allgemeinbeleuchtungsbereich oder im Theaterbeleuchtungsbereich. Die Kaltlichtbeschichtung reflektiert dabei nur die sichtbare Strahlung und transmittiert die Wärmestrahlung.

Aufgrund der heutigen Scheinwerfergeometrien in Kraftfahrzeugen mit metallisch beschichteten Reflektoren führt die so reflektierte Infrarotstrahlung zu lokal hohen thermischen Belastungen an Komponenten, welche im Strahlengang folgen, wie z.B. Linsen, Abdeckscheiben u.a.. Aufgrund dieser Belastung müssen diese Komponenten heute in der Regel als Glassubstrate eingesetzt werden und/oder durch spezielle Beschichtungen vor der Wärmestrahlung geschützt werden.

In der Automobilindustrie geht es in zunehmendem Maße um die Einsparung von Gewicht, da eine Gewichtsreduzierung zur Einsparung von Kraftstoff beiträgt. Aus diesem Grunde wird versucht, soweit wie möglich Kunststoff als Austauschstoff für andere Materialien, beispielsweise für Stahl, zu verwenden. Im Falle des Glasreflektors war dies bisher jedoch nicht möglich. Die reflektierende Fläche müßte nämlich mit einem Kaltlichtspiegel versehen werden. Dies scheiterte bisher daran, daß es nicht möglich war, einen solchen Kaltlichtspiegel dauerhaft an einem Kunststoff zu fixieren.

Es wird somit gemäß der Erfindung der Grundkörper des Reflektors aus Kunststoff hergestellt, mit allen seinen Vorteilen, die vor allem in einem niedrigen spezifischen Gewicht und in einer leichten Verformbarkeit bestehen. Auch entfällt das Problem des Splitterschutzes.

Weiterhin wird gemäß der Erfindung die reflektierende Fläche als Kaltlichtspiegel ausgebildet. Sie besteht zweckmäßigerweise aus einer Mehrzahl von Schichten unterschiedlicher Brechungskoeffizienten. Diese Beschichtung reflektiert die sichtbare Strahlung und läßt die Infrarotstrahlung transmittieren (Kaltlichtspiegel-Prinzip).

Gemäß der Erfindung hat es sich gezeigt, daß die Wechselschichten zuverlässig und dauerhaft am Kunststoff fixierbar sind, und zwar dann, wenn sie mit ganz bestimmten Verfahren auf das Kunststoffsubstrat aufgebracht werden, nämlich mittels des Plasma-Impuls-Verfahrens oder mittels chemischer Bedampfung oder mittels phasen-impuls-chemischer Bedampfung.

Aufgrund der Temperaturbelastung kommen nur Hochleistungskunststoffe in Frage, die mindestens bis 100°C stabil sind, besser höher. Um harte, dauerhafte Kaltlichtschichtsysteme aufzubringen, sind in der Regel hohe thermische Belastungen des Substrates erforderlich, die ein Kunststoffreflektor nicht ohne Schaden verträgt. Hier bietet sich das PICVD-Verfahren an, welches als gepulstes Verfahren nur einen geringen Energieeintrag in das Substrat bewirkt und so die Substrattemperatur gering hält. Andererseits werden in den Pulsen hohe Plasmaenergiedichten erzeugt, die harte und dauerhafte Schichten hervorbringen. Die Beschichtung ist, wie erwähnt, eine Mehrfachbeschichtung. Die einzelnen Schichten sind optische Funktionsschichten wie zum Beispiel eine Anti-Reflex-Schicht, aber auch Multifunktionsschichten mit besonderen mechanischen Eigenschaften wie beispielsweise eine hydrophobe Deckschicht, die sogenannte Reinigungsschicht, die sich mechanisch leicht reinigen läßt. Auch Schichten mit besonderen optischen und sonstigen Eigenschaften kommen in Betracht. Zwischen den Funktionsschichten und dem Substrat wird im allgemeinen eine sogenannte Haftvermittler-Schicht aufgebracht, hier ganz allgemein "Zwischenschicht" genannt. Dieser kommt entscheidende Bedeutung für die Brauchbarkeit des ganzen Produktes zu. Sie ist nämlich für die Haftung des gesamten Schichtpaketes am Substrat verantwortlich. Die Zwischenschicht kann eine einzige homogene Schicht sein. Sie kann auch eine Mehrlagenschicht sein. Dabei bilden die einzelnen Schichten einen Gradienten, ausgehend von einer Schicht, die unmittelbar auf das Substrat folgt und diesem als Organikum wesensgleich oder ähnlich ist, bis zu einer Schicht, die der nächstfolgenden Funktionsschicht nahe ist und die dieser als Anorganikum wesensgleich oder ähnlich ist.

Im übrigen ist die Erfindung bei jeglicher Art von Beschichtung anwendbar. Die Schichteigenschaften lassen sich durch die eingesetzten Rohstoffe sowie durch die Betriebsparameter der Anlage steuern. Die Schichteigenschaften lassen sich in weiten Grenzen verändern. Die Zwischenschicht wird im allgemeinen eine sogenannte Gradientenschicht sein, die aus mehreren Schichten zusammengesetzt ist, und bei der die substratnahe Schicht dem Substrat wesensgleich ist, und die substratferne Schicht den Funktionsschichten wesensgleich ist.

Die Erfindung läßt sich auch anwenden bei Verwendung des sogenannten Remote-PICVD-Verfahrens. Hierbei sind bekanntlich Plasmaraum und Beschichtungsraum voneinander getrennt. Aus dem Plasmaraum werden angeregte Species in den Beschichtungsraum geleitet.

Die Erfindung ist anhand der Zeichnung näher erläutert. Darin ist im einzelnen folgendes dargestellt:
Figur 1 veranschaulicht in einer perspektivischen Schnittdarstellung einen erfindungsgemäßen Körper.
Figur 2 zeigt in schematischer Darstellung eine Vorrichtung zum Beschichten eines Substrates.

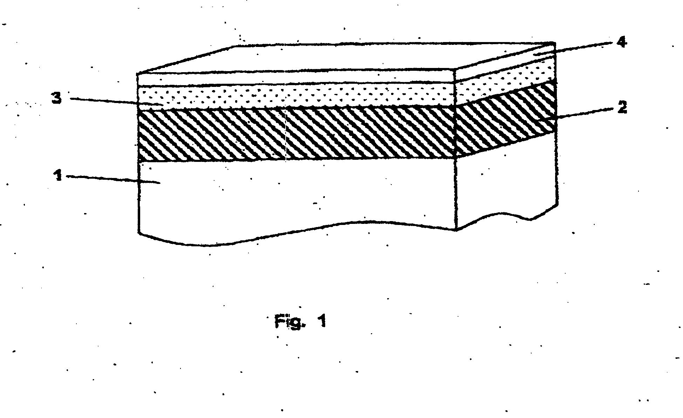

In Figur 1 erkennt man ein Substrat 1. Auf dieses ist eine Zwischenschicht 2 aufgebracht. Diese hat eine Haftvermittler - Antikratz-Funktion. Sie ist zuverlässig am Substrat verankert, weil sie erfindungsgemäß bei minimaler Energiebelastung auf das Substrat aufgebracht wurde.

Die Zwischenschicht 2 ist eine sogenannte Gradientenschicht, aufgebaut aus mehreren Einzelschichten unterschiedlicher Zusammensetzung. Dabei ist die substratnahe Einzelschicht dem Substrat 1 wesensgleich, während die obere, substratferne Schicht einer nachfolgenden Schicht wesensgleich ist.

Die nachfolgende Schicht ist die Funktionsschicht 3. Diese übt beispielsweise optische Funktionen aus.

Den Abschluß bildet eine Deckschicht 4.

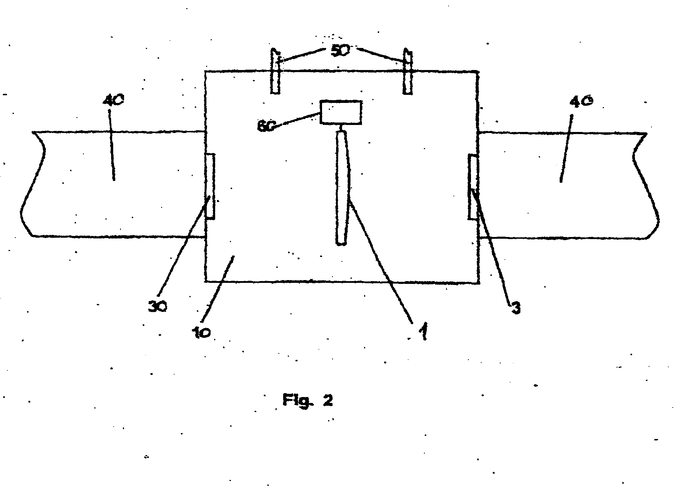

Die in Figur 2 gezeigte Vorrichtung weist die folgenden Komponenten auf:
ein Beschichtungsreaktor 10 trägt das Substrat 1. Man erkennt ein Mikrowellenfenster 30, einen Mikrowellenhohlleiter 40, einen Gaseinlaß 50 sowie einen Substrathalter 60.

### Bezugszeichenliste

- 1: Substrat
- 2: Zwischenschicht
- 3: Funktionsschicht
- 4: Deckschicht
- 10: Beschichtungsreaktor
- 30: Mikrowellenfenster
- 40: Mikrowellenhohlleiter
- 50: Gaseinlaß
- 60: Substrathalter

## Patentansprüche

1. Verfahren zum Herstellen eines Gegenstandes, der optische Schichten (3) aufweist, mit den folgenden Verfahrensschritten:
1.1 auf einem Substrat (1) aus Cycloolefin-Polymeren, i.e. COP, oder Cycloolefin-Copolymeren, i.e. COC, wird eine Haftvermittlerschicht (2) ausgebildet;
1.2 auf der Haftvermlttlerschicht (2) werden mehrere optische Schichten (3) aufgebracht; die einen Kaltlichtspiegel ausbilden; **dadurch gekennzeichnet, dass**
1.3 die Haftvermittlerschicht (2) als Gradientenschicht zwischen dem Substratmaterial und dem Material der nachfolgenden optischen Schicht ausgebildet ist; wobei die Gradientenschicht aus einzelnen Schichten, ausgehend von einer Schicht, die unmittelbar auf das Substrat folgt und diesem als Organikum wesensgleich ist, bis zu einer Schicht, die der nächstkommenden optischen Schicht (3) nahe ist und dieser als Anorganikum wesensgleich ist, ausgebildet ist; und
1.4 dass die Haftvermittlerschicht (2) und die optischen Schichten (3) mittels einer chemischen Plasma-Puls-Bedampfung i.e PICVD, ausgebildet werden, wobei die Gesamtdauer der Plasmaeinwirkung wenigstens 1/1000 der gesamten einwirkungsfreien Zeitspanne während der Plasmabehandlung beträgt, und höchstens gleich dieser Zeitspanne ist; und
1.5 dass ein Einwirkungsimpuls der Plasmabeaufschlagung zwischen 0,1 und 10 ms, vorzugsweise zwischen 0,5 und 5 ms dauert.

2. Verfahren nach Anspruch 1, **dadurch gekennzeichnet, dass** die optischen Schichten (3) unterschiedliche Brechungskoeffizienten aufweisen.

3. Verfahren nach einem der Ansprüche 1 bis 2, **dadurch gekennzeichnet, dass** die Beschichtungsrate bei der Plasma-Einwirkung pro Zeiteinheit und pro Flächeneinheit > 10 Nanometer/min ist, vorzugsweise > 100 Nanometer/min.

## Claims

1. A method for producing an object which comprises optical layers (3), comprising the following method steps:
1.1. a bonding agent layer (2) is formed on a substrate (1) made of cycloolefin polymers, i.e. COP, or cycloolefin copolymers, i.e. COC;
1.2. several optical layers (3) which form a cold-light reflector are applied to the bonding agent layer (2);
**characterized in that**
1.3.the bonding agent layer (2) is arranged as a gradient layer between the substrate material and the material of the subsequent optical layer, with the gradient layer being formed from individual layers, starting from a layer which directly follows the substrate and is similar to the same as an organic chemical, up to a layer which is close to the next following optical layer (3) and is similar to the same as an inorganic chemical, and that
1.4. the bonding agent layer (2) and the optical layers (3) are formed by means of a plasma-pulse chemical vapor deposition, i.e. PICVD, with the total duration of the plasma action being at least 1/1000^{th} of the total action-free time interval during the plasma treatment and being at most equal to said time interval, and that
1.5. an action pulse of plasma action is between 0.1 and 10 ms, preferably between 0.5 and 5 ms.

2. A method according to claim 1, **characterized in that** the optical layers (3) have different refractive indexes.

3. A method according to one of the claims 1 to 2, **characterized in that** the coating rate during plasma action per unit of time and per unit of surface area is > 10 nanometres/min, preferably > 100 nanometres/min.

## Revendications

1. Procédé de fabrication d'un objet, présentant des couches optiques (3), comportant les étapes suivantes :
1.1 sur un substrat (1) en polymère de cyclo-oléfine, dans la suite COP, ou copolymère de cyclo-oléfine, dans la suite COC, on constitue une couche de promoteur d'adhésion (2) ;
1.2 sur la couche de promoteur d'adhésion (2), on applique plusieurs couches optiques (3) ; constituant un réflecteur de lumière froide ; **caractérisé en ceci**
1.3 que la couche de promoteur d'adhésion (2) est constituée comme couche à gradient entre le matériau du substrat et la couche optique suivante ; la couche à gradient étant constituée de couches différentes en partant d'une couche suivant immédiatement le substrat et lui étant semblable comme substance organique, jusqu'à une couche, qui est proche de la couche optique suivante (3) et lui est semblable comme substance inorganique ; et
1.4 que la couche de promoteur d'adhésion (2) et les couches optiques (3) sont constituées au moyen d'une couche de plasma déposée en phase vapeur, dans la suite PICVD, la durée total d'exposition au plasma étant d'au moins de 1/1000 de la durée totale sans exposition au plasma au cours du traitement par plasma et étant au maximum égale à cette durée ; et
1.5 que l'impulsion d'action du traitement par plasma dure entre 0,1 et 10 ms, de préférence entre 0,5 et 5 ms.

2. Procédé selon la revendication 1, **caractérisé en ce**ci que les couches optiques (3) présentent différents coefficients de réfraction.

3. Procédé selon une des revendications 1 à 2, **caractérisé en ce**ci que le taux d'enduction lors de l'exposition au plasma par unité de temps et par unité de surface est > 10 nanomètres/mn, de préférence > 100 nanomètres/mn.
